# EUROPÄISCHE PATENTSCHRIFT

(11) **EP 1 389 820 B1**
(45) Veröffentlichungstag und Bekanntmachung des Hinweises auf die Patenterteilung: **10.09.2014**
(21) Anmeldenummer: 03016373.7
(22) Anmeldetag: 19.07.2003
(51) Int. Cl.: H02M 7/72, H01L 25/04, H01L 27/088

(54) **Induktivitätsarme Schaltungsanordnung für Leistungshalbleitermodule**
Low inductance circuit arrangement for power semiconductor modules
Disposition de circuit à faible inductance pour modules à sémi-conducteur de puissance

(30) Priorität: 16.08.2002 DE 10237561
(43) Veröffentlichungstag der Anmeldung: 18.02.2004
(73) Patentinhaber: SEMIKRON Elektronik GmbH & Co. KG, 90431 Nürnberg (DE)
(72) Erfinder: Heilbronner, Heinrich, Dr., 90547 Stein (DE); Stockmeier, Thomas, Dr., 90431 Nürnberg (DE)

(56) Entgegenhaltungen:
- EP-A- 0 588 094
- EP-A- 1 143 603
- DE-A- 3 937 045
- DE-A- 19 618 978
- US-A- 4 458 305
- US-A- 4 907 068
- US-A- 5 422 440

## Beschreibung

Die Erfindung beschreibt eine kompakte, induktivitätsarme Schaltungsanordnung für moderne Leistungshalbleitermodule, bei welchen die Verwendung schnell und verlustarm schaltender Halbleiterschalter bevorzugt ist. Als Leistungshalbleiterbauelemente sind für diese Schaltungsanordnung daher besonders MOSFETs oder Insulated- Gate- Bipolar- Transistoren (IGBT) mit antiparallel dazu geschalteten Freilaufdioden geeignet. Derartige Schaltungsanordnungen und damit beispielhaft aufgebaute Stromrichter müssen niederinduktiv ausgelegt werden um die Entstehung von Spannungsspitzen insbesondere bei Abschaltvorgängen zu vermeiden. Dies bedeutet, dass Streuinduktivitäten im Zwischenkreis, an den Anschlussleitem sowie auf der Substratoberfläche der Schaltungsanordnung klein sein müssen. Streuinduktivitäten, die in ihrer Summe den Bereich von ca. 20 nH erreichen, können bei Niedervolt- MOSFET bereits zu Spannungsspitzen führen, welche die Leistungshalbleiterschalter zerstören können. Weiterhin gefordert ist eine kompakte Bauweise einerseits um entsprechende Gesamtsysteme aufbauen zu können, die einen geringen Platzbedarf aufweisen, andererseits um die Herstellungskosten der Leistungshalbleitermodule zu verringern. In gleicher Weise eignet sich die Erfindung zum Aufbau von Gleichrichteranordnungen, in denen bevorzugt Leistungsdioden und / oder Leistungsthyristoren zum Einsatz kommen.

Zum Stand der Technik zählen Einzelschalter und Leistungshalbleitermodule mit einzelnen konstruktiven Maßnahmen zur Reduzierung parasitärer Induktivitäten, wie sie z.B. bekannt sind aus EP 0 277 546, DE 39 37 045 oder DE 100 37 533.

In der EP 0 277 546 wird für einen Einzelschalter ein Verfahren zur Reduzierung der parasitären Induktivitäten in den Gleichstromzuleitungen beschrieben. Hierbei werden die beiden Gleichstromzuleitungen eng benachbart und zumindest teilweise parallel zueinander angeordnet. Dies bewirkt eine kleine stromumflossene Fläche in dem Bereich der eng benachbarten Anordnung der Zuleitungen und damit eine geringe Induktivität dieses Zuleitungsabschnittes. Die Gleichstromzuleitungen sind hier mit dem Substrat stoffschlüssig, mittels einer Lötung, verbunden.

In der DE 39 37 045 wird für eine Halbbrücke ein Verfahren zur Reduzierung der parasitären Induktivitäten in den Gleichstromzuleitungen beschrieben. Hierbei werden die beiden Gleichstromzuleitungen benachbart, allerdings mit der Wechselstromzuleitung zwischen Plus- und Minuszuleitung, und zumindest teilweise parallel zueinander angeordnet. Dies bewirkt ebenfalls eine Verkleinerung der stromumflossenen Fläche in dem Bereich der benachbarten Anordnung der Zuleitungen und damit eine relativ geringe Induktivität dieses Zuleitungsabschnittes. Die Gleichstrom- sowie die Wechselstromleitungen sind hier ebenfalls stoffschlüssig, mittels einer Lötung, mit dem Substrat verbunden.

Die DE 100 37 533 beschreibt eine Schaltungsanordnung mit sehr geringen parasitären Induktivitäten. Hierzu wird vorgeschlagen, die einzelnen Leistungstransistoren der beiden Leistungsschalter in Reihe anzuordnen und fingerartige Kontaktelemente zwischen den einzelnen Leistungstransistoren anzuordnen. Mit dieser druckkontaktierten Anordnung werden die bislang geringsten parasitären Induktivitäten in derartigen Schaltungsanordnungen erreicht.

Zum Stand der Technik zählen weiterhin kompakte Leistungshalbleitermodule wie sie beispielhaft in der DE 197 19 703 beschrieben sind. Derartige Leistungshalbleitermodule bestehen aus keramischen Substraten mit darauf aufgebrachten Verbindungsbahnen, auf denen Halbleiterbauelemente angeordnet sind. Diese Halbleiterbauelemente sind mittels Löten mit den Verbindungsbahnen verbunden und weisen Bondverbindungen zu anderen Halbleiterbauelementen auf. Die an der Gehäusewandung befindlichen Anschlusselemente weisen Teilflächen auf, von denen ausgehend Drahtbondverbindungen zu einzelnen Verbindungsbahnen des Substrates hergestellt werden.

Aus der EP 1 143 603 A2 ist ebenfalls ein Leistungshalbleitermodul bekannt, mit einer Grundplatte, einer Mehrzahl von Substraten mit Leistungshalbleiterbauelement sowie Gleich- und Wechselstromanschlussleitern. Die Gleichstromanschlussleiter weisen sind bandartig ausgebildet und eng benachbart zueinander angeordnet. Sie wiesen Anschlussflächen zur Drahtbondverbindung mit den Substraten auf.

In der EP 0 277 546 liegen die den Einzelschalter bildenden Transistoren eng benachbart zueinander, dennoch kann der Strom auf unterschiedlichen, vor allem unterschiedlich langen Wegen durch die Schaltungsanordnung fließen. Daraus resultieren unterschiedliche vom Strom umflossene Flächen, unterschiedliche Induktivitäten für die verschiedenen Leitungswege und auch unterschiedliche ohmsche Widerstände dieser Leitungswege. Speziell der Aufbau einer Halbbrücke mit derartigen Einzelschaltern kann aufgrund der dafür notwendigen externen Verschaltung keinesfalls niederinduktiv erfolgen. Dies führt in der Summe der Eigenschaften zu einer gewissen Reduzierung der parasitären Induktivitäten des Gesamtsystems Zwischenkreis - Wechselrichter. Allerdings sind damit noch nicht alle Forderungen an eine Minimierung der parasitären Induktivitäten erfüllt. Ebenso wenig kann eine Anordnung von Einzelschaltern mit jeweils einem eigenen Gehäuse die Anforderungen an einen kompakten und / oder kostengünstigen Aufbau des Gesamtsystems erfüllen.

In der DE 39 37 045 wird das Ziel geringer parasitärer Induktivität aus zwei wesentlichen Gründen verfehlt. Erstens sind die Gleichstromanschlussleiter nicht in minimalem Abstand zueinander angeordnet, da hier der Wechselstromanschlussleiter zwischen den beiden Gleichstromanschlussleitern angeordnet ist. Somit ist die stromumflossene Fläche im Bereich der Gleichstromanschlussleiter nicht minimal und daher sind auch die Induktivitäten für diesen Bereich nicht minimal. Zweitens sind die Leistungstransistoren des ersten und zweiten Leistungsschalters relativ weit von einander angeordnet, was ebenfalls die parasitären Induktivitäten erhöht. Dem Ziel kompakter Aufbauten widersprechen bei der vorgestellten Anordnung die relativ großen parallel zum Substrat ausgerichteten Flächen unterhalb der Anschlussleiter für den Plus- und den Wechselstromsanschluss.

Der vorliegenden Erfindung liegt die Aufgabe zu Grunde eine Schaltungsanordnung vorzustellen, die geringe parasitäre Induktivitäten der gesamten Anordnung aufweist, die einen verringerten ohmschen Widerstand der Stromzu- und ableitungen zu den Halbleiterbauelementen aufweist und die einen geringen Gesamtflächenbedarf für die Halbleiterbauelemente und die Anschlussleiter aufweist, wobei die Anschlussleiter die für Halbleiterbauelemente nutzbare Fläche des Substrates nur geringfügig verringern.

Diese Aufgabe wird gelöst durch eine Schaltungsanordnung nach dem Anspruch 1, spezielle Ausgestaltungen finden sich in den Ansprüchen 2 bis 8. Die Schaltungsanordnung, bestehend aus mindestens einem elektrisch isolierenden Substrat mit darauf befindlichen gegeneinander isolierten metallischen Verbindungsbahnen auf diesen Verbindungsbahnen befindlichen Leistungshalbleiterbauelementen sowie mindestens zwei

Gleichstromanschlussleitern und mindestens einem Wechselstromanschlussleiter weist folgende erfinderische Merkmale auf:
- Die Gleichstromanschlussleiter sind als Bänder ausgeführt, wovon jeweils zwei unterschiedlicher Polarität eng benachbart zueinander angeordnet und nur durch eine elektrische Isolierung voneinander getrennt angeordnet sind. Dadurch werden einerseits kompakte Ausmaße im Bereich der Anschlussleiter sowie anderseits eine niederinduktive Ausgestaltung derselben gewährleistet. Vorteilhafterweise weisen die Anschlussleiter Kontaktelemente, wie beispielhaft Schraubanschlüsse, zur externen Kontaktierung auf.
- Die Gleichstromanschlussleiter sind zumindest in einem wesentlichen Teilabschnitt parallel und vorteilhafterweise eng benachbart zur Substratoberfläche und / oder den darauf befindlichen Verbindungsbahnen sowie elektrisch isoliert von diesen Verbindungsbahnen angeordnet.
- Vorteilhafterweise ist der mindestens eine Wechselstromanschlussleiter ebenfalls zumindest in einem Teilabschnitt eng benachbart zur Substratoberfläche und / oder den darauf befindlichen Verbindungsbahnen und elektrisch isoliert von diesen angeordnet.
- Mindestens ein Anschlussleiter weist mindestens ein Flächenelement auf, welches parallel zur Substratoberfläche angeordnet ist. Dieses Flächenelement weist seinerseits Verbindungen zu mindestens einem Leistungshalbleiterbauelement und / oder zu mindestens einer Verbindungsbahn auf.

Diese Verbindungen sind vorteilhafterweise Drahtbondverbindungen. Weiterhin ist es vorteilhaft, wenn unter oder nahe benachbart zu dem Flächenelement ein oder mehrere Fußelemente vorhanden sind um den Anschlussleiter auf dem Substrat und / oder einer Verbindungsbahn abzustützen.

Vorteilhaft an der erfinderischen Ausgestaltung der Schaltungsanordnung ist neben den geringen parasitären Induktivitäten und den durch o.g. Anordnung realisierbaren kompakten Abmessungen auch der geringere ohmsche Widerstand der Zuleitungen zu den Halbleiterbauelementen, da der Strom im Wesentlichen innerhalb der Anschlussleiter fließt und nur noch einen vergleichsweise kurzen Weg innerhalb der Verbindungsbahnen, die nach dem Stand der Technik einen höheren ohmschen Widerstand aufweisen.

Die Erfindung wird anhand eines Ausführungsbeispiels in Verbindung mit den Fig. 1 bis 5 näher erläutert.
- Fig. 1: zeigt schematisch Teile einer erfindungsgemäßen Schaltungsanordnung in Draufsicht.
- Fig. 2: zeigt schematisch Teile einer erfindungsgemäßen Schaltungsanordnung im Querschnitt.
- Fig. 3: zeigte eine dreidimensionale Skizze eines Anschlussleiters der erfindungsgemäßen Schaltungsanordnung.
- Fig. 4: zeigt eine erfindungsgemäße Schaltungsanordnung in Halbbrückentopologie.
- Fig. 5: zeigt eine erfindungsgemäße Schaltungsanordnung in 3- Phasen Wechselrichtertopologie.

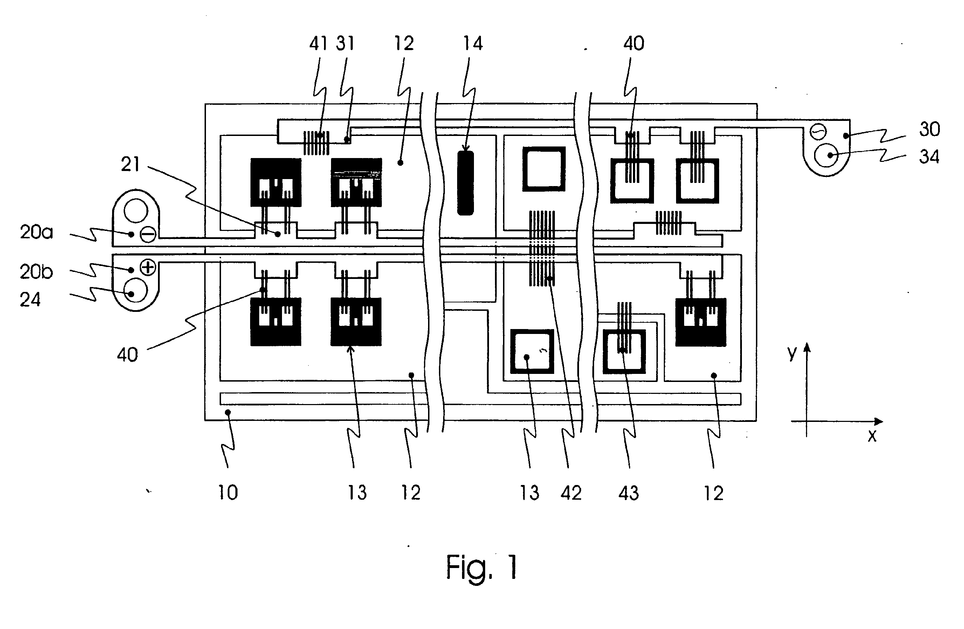

Fig. 1 zeigt schematisch einzelne Teilaspekte einer erfindungsgemäßen Schaltungsanordnung in Draufsicht um die verschiedenen möglichen Ausgestaltungen darzustellen. Die Schaltungsanordnung besteht aus einem Substrat (10), welches nach dem Stand der Technik als eine isolierende Keramik beispielhaft aus Aluminiumoxid ausgeführt ist. Auf diesem Substrat sind nach einem Direktverbindeverfahren metallische Verbindungsbahnen (12) aufgebracht. Diese Verbindungsbahnen bilden einzelne voneinander isolierte Bereiche auf dem Keramiksubstrat (10). Derartige Kombinationen aus einem keramischen Substrat (10) und darauf schaltungsgerecht angeordneten Verbindungsbahnen sind beispielhaft als DCB- (direct copper bonding) Substrate bekannt und werden für Leistungshalbleitermodule vielfach eingesetzt.

Auf dem DCB- Substrat (10, 12) sind eine Mehrzahl von Leistungshalbleiterbauelementen (13) stoffschlüssig durch Löten aufgebracht. Für Leistungshalbleitermodule haben sich als Leistungshalbleiterbauelemente IGBTs (insulated gate bipolar transistor) und mit diesen antiparallel geschaltete Freilaufdioden oder MOS-FETs bewährt. Alternativ können auch Thyristoren eingesetzt werden. Vorteilhafterweise sind auf den DCB- Substraten von Leistungshalbleitermodulen nach dem Stand der Technik weitere Bauelemente (14) wie beispielsweise Strom- oder Temperatursensoren angeordnet. Die Verbindungen der Leistungshalbleiterbauelemente (13) mit weiteren Verbindungsbahnen (12) wird nach dem Stand der Technik meist mittels Drahtbondverbindungen (43) erreicht.

Zur elektrischen Verbindung der Leistungshalbleiterbauelemente mit externen Anschlüssen weist die Schaltungsanordnung Anschlussleiter (20, 30) auf. Diese werden durch je einen flächigen Metallkörper gebildet, der zur externen Kontaktierung Kontaktelemente (24, 34) aufweist, die als Schraubanschlüsse ausgebildet sind. Ein nicht gezeichnetes Gehäuse weist Aussparungen für die Anschlussleiter (20, 30) auf, wobei diese durch die genannten Aussparungen nach außen ragen.

Die Gleichstromanschlussleiter (20a, 20b) sind zur Erzielung geringer parasitärer Induktivitäten in ihrem gesamten Verlauf eng benachbart und nur durch eine zur elektrischen Isolation der beiden notwendigen Schicht voneinander getrennt. Weiterhin ist es vorteilhaft zu Erzielung möglichst geringer parasitärer Induktivitäten, wenn die Gleichstromanschlussleiter (20) in wesentlichen Teilabschnitten eng benachbart zum Substrat (10) und / oder zu den Verbindungsbahnen angeordnet sind. Hierzu muss allerdings eine elektrische Isolation zwischen der Verbindungsbahn und dem Anschlussleiter angeordnet werden, sofern nicht eine elektrisch Verbindung zwischen ihnen schaltungsgerecht ist.

Der Wechselstromanschlussleiter (30) ist derart angeordnet, dass möglichst kurze Drahtbondverbindungen zu den ihm zugeordneten Verbindungsbahnen und / oder Halbleiterbauelementen möglich sind. Dies ist vorteilhaft, da hierdurch ein kompakter Aufbau des Leistungshalbleitermoduls möglich ist.

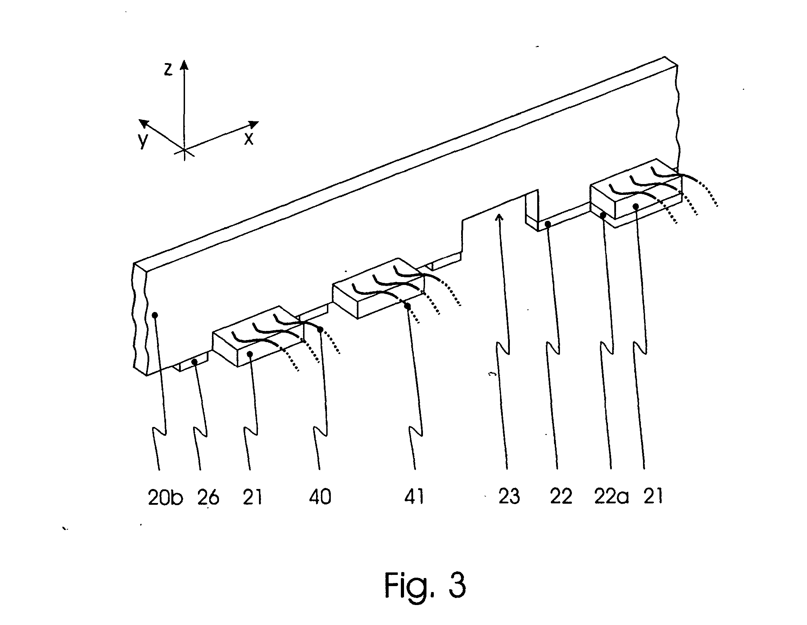

Die Anschlussleiter (20, 30) können Ausnehmungen (siehe Fig. 3 - 23) aufweisen, in deren Bereich die Anschlussleiter nicht eng benachbart zum Substrat bzw. den Verbindungsbahnen angeordnet sind um beispielhaft Drahtbondverbindungen (42) zwischen anderen Schaltungsteilen, hier zwei Verbindungsbahnen (12), zu gestatten.

Zur internen Kontaktierung, also der Kontaktierung zu Leistungshalbleiterbauelementen (13) und / oder mit Verbindungsbahnen (12), weisen die Anschlussleiter (20, 30) eine Mehrzahl von Flächenelementen (21, 31) auf. Diese Flächenelemente sind als eine parallel zum Substrat angeordnete Lasche des Anschlussleiters ausgebildet. Diese Lasche weist auf ihre vom Substrat abgewandten Seite eine genügend große Fläche auf um Bondfüße, also die Kontaktierungen von Drahtbondverbindungen (40, 41), aufnehmen zu können. Mittels dieser Flächenelemente (21, 31) und den von ihnen ausgehenden Drahtbondverbindungen (40, 41) werden die Anschlussleiter schaltungsgerecht mit Verbindungsbahnen (12) und / oder mit Halbleiterbauelementen (13) kontaktiert. Eine direkte Kontaktierung mittels einer Drahtbondverbindung (40) des Flächenelements (21, 31) mit einem Halbleiterbauelement (13) erweist sich hierbei als besonders vorteilhaft, weil dadurch der Flächenverbrauch der Kontaktierung minimal ist.

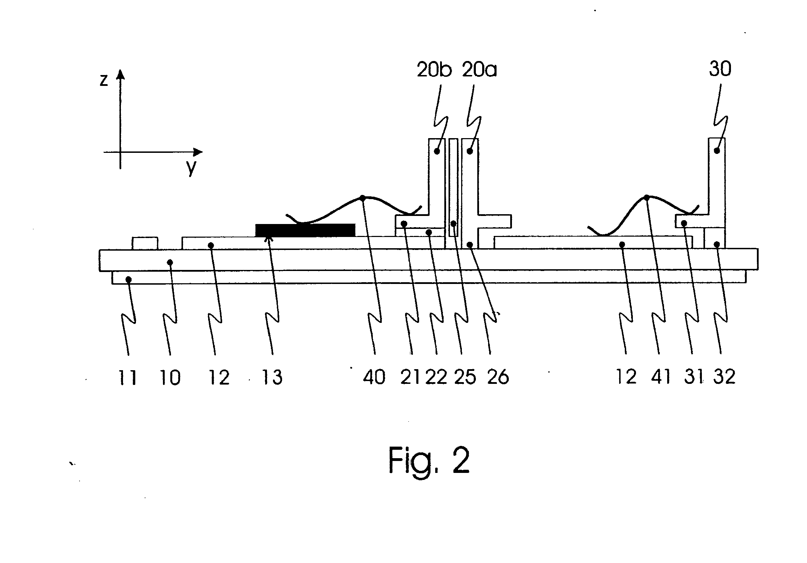

Fig. 2 zeigt schematisch Teile der erfindungsgemäßen Schaltungsanordnung nach Fig. 1 im Querschnitt. Das DCB- Substrat besteht, wie nach dem Stand der Technik üblich, nicht nur aus einem keramischen Substrat (10) sowie auf seiner Oberseite angeordneten schaltungsgerechten Verbindungsbahnen (12), sondern auch aus einer in der Regel vollflächigen Metallkaschierung (11) auf der Unterseite des keramischen Substrates, aufgebracht nach dem gleichen Verfahren, in gleicher Stärke und aus dem gleichen Metall, wie die Verbindungsbahnen (12). Auf den schaltungsgerecht angeordneten Verbindungsbahnen (12) auf der Oberseite des Substrates sind wiederum Leistungshalbleiterbauelemente (13) aufgelötet.

Die Gleichstromanschlussleiter (20) sind mit ihrer schmalen Längsseite zum Substrat gerichtet angeordnet und weisen zusätzliche Flächenelemente (21) auf. Diese Flächenelemente sind derart ausgestaltet, dass von ihnen ausgehend Drahtbondverbindungen zu Leistungshalbleiterbauelementen (13) und / oder zu Verbindungsbahnen möglich sind. Die beiden Gleichstromanschlussleiter (20) sind eng benachbart zueinander angeordnet und nur durch eine Isolationsfolie (25) elektrisch isoliert und voneinander beabstandet.

Der Wechselstromanschlussleiter (30) weist in analoger Weise zu den Gleichstromanschlussleitern (20) ebenfalls Flächenelemente (31) für Drahtbondverbindungen (41) auf, die in der gezeigten Form zur elektrischen Verbindung zu einer Verbindungsbahn (12) dienen, aber ebenso zur Verbindung zu Halbleiterbauelementen (13) geeignet sind.

Alle Anschlussleiter sind eng benachbart zum Substrat und / oder zu den Verbindungsbahnen angeordnet. Zur Beabstandung hierzu weist die Schaltungsanordnung Abstandshalter (22, 32) und / oder Fußelemente (26) auf. Die Abstandshalter dienen gleichzeitig als Isolationsschicht zur elektrischen Isolierung z.B. gegenüber den Verbindungsbahnen (12). Diese Abstandhalter sind unterhalb der Anschlussleiter angeordnet. An manchen Flächenelementen (21, 31), in bestimmten Arten von Leistungshalbleitermodulen auch an allen, kann es vorteilhaft sein, diese als Isolationsschicht dienenden Abstandhalter (22) auch unterhalb dieser Flächenelemente (21, 31) anzuordnen. Die Fußelemente (26) stellen einen Kontakt zum Substrat (10) her. Sie sind Teil des Anschlussleiters (20, 30) und unter oder neben den Flächenelementen (21, 31) angeordnet. Die Fußelemente (26) dienen wie auch die Abstandshalter (22) bei der Herstellung der Drahtbondverbindung zur Vermeidung von Schwingungen des Anschlusselements.

Fig. 3 zeigt nochmals, hier in einer dreidimensionale Skizze, einen Anschlussleiter (20, 30) der erfindungsgemäßen Schaltungsanordnung. Der Anschlussleiter (20b) besteht, wie die anderen Anschlussleiter ebenfalls, aus einem flächigen Metallkörper vorzugsweise aus Kupfer mit einer veredelten, beispielhaft versilberten, Oberfläche. An diesem Metallkörper angeordnet sind, beispielhaft mittels Stanz- Biege- Technik hergestellte Flächenelemente (21, 31) sowie Fußelemente (26).

Die Flächenelemente dienen der elektrischen Kontaktierung von Verbindungsbahnen (12) und / oder Halbleiterbauelementen (13) mittels Drahtbondverbindungen (40, 41). Die Fußelemente dienen der Abstützung des Anschlussleiters auf einem nicht mit einer Verbindungsbahn (12) versehenen Teil des Substrats (10).

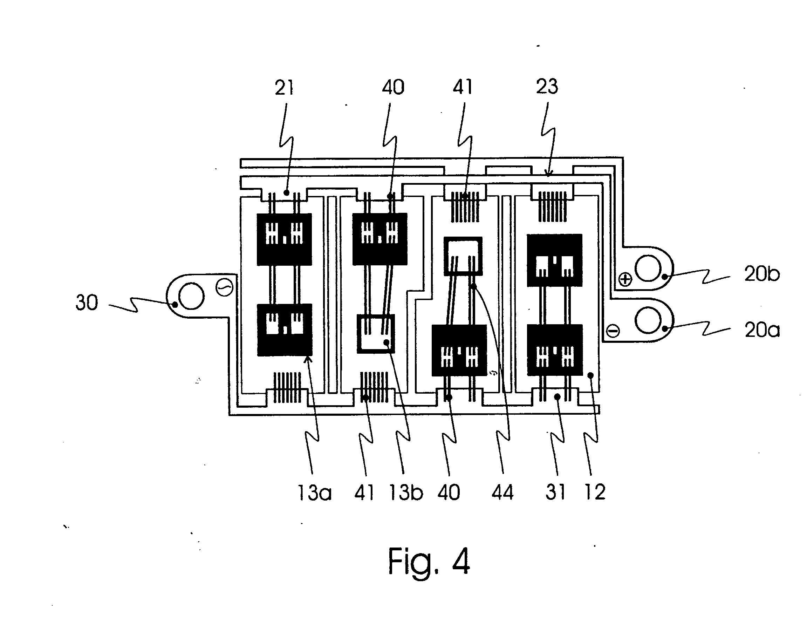

Weiterhin kann ein Anschlussleiter eine oder mehrere Aussparungen (23) aufweisen um beispielhaft Drahtbondverbindungen rechtwinklig zum Verlauf des Anschlussleiters zu gestatten (vgl. Fig. 1 - 42). Ebenso können eine oder mehrere Aussparungen dazu dienen, dass Flächenelemente (21) eines benachbart angeordneten Anschlussleiters unter dem die Aussparungen aufweisenden Anschlussleiter hindurch ragen (vgl. Fig. 4 und 5 - 23).

Zur elektrischen Isolierung und / oder Beabstandung zum Substrat und / oder zu Verbindungsbahnen mit Wirkung analog zum Fußelement ist unterhalb des Anschlussleiters ein Abstandshalter (22) angeordnet. Dieser Abstandshalter (22a) kann bis unterhalb der Flächenelemente (21, 31) ausgedehnt sein.

Fig. 4 zeigt eine erfindungsgemäße Schaltungsanordnung in Halbbrückentopologie. Die beiden Gleichstromanschlussleiter (20a, 20b) sind in ihrem gesamten Verlauf eng benachbart zueinander angeordnet. Der Minus- Gleichstromanschlussleiter (20a) weist an zwei Stellen (23) Ausnehmungen (siehe auch Fig. 3 - 23) auf, durch welche Flächenelemente (21) des Plus- Gleichstromanschlussleiters (20b) hindurchragen. Somit weisen die beiden an einer Längsseite der Halbbrücke angeordneten Gleichstromanschlussleiter Kontaktelemente zur Kontaktierung der Verbindungsbahnen (12) bzw. der Leistungshalbleiterbauelemente (13) auf. Die Halbbrücke selbst besteht aus zwei Leistungsschaltern, die jeweils durch 3 IGBTs (13a) gebildet werden. Jedem Leistungsschalter ist eine Leistungsdiode (13b) zugeordnet und antiparallel zu diesem geschaltet. Die auf der Unterseite, der dem ersten Halbleiterschalter zugeordneten IGBTs angeordneten Kollektoren sind mit dem Plus- Gleichstromstromanschlussleiter (21b) bzw. dessen Flächenelementen (21) verbunden, indem von diesen Flächenelementen Drahtbondverbindungen (41) zu den diesen IGBTs zugeordneten Verbindungsbahnen (12) angeordnet sind. Auf gleiche Weise ist die Kathode der antiparallel geschalteten Diode (13b) mit dem Plus- Gleichstromanschlussleiter (20b) verbunden. Die Emitter dieser IGBTs sind zum Teil miteinander mittels Drahtbondverbindungen (44) verbunden sowie direkt mit dem Wechselstromanschlussleiter (30) mittels Drahtbondverbindungen (40). Die Anode der Leistungsdiode (13b) ist ebenfalls mittels Drahtbondverbindungen (44) mit einem Emitter eines IGBTs und über dessen Drahtbondverbindung (40) mit dem Wechselstromanschlussleiter (30) verbunden.

Die Kollektoren der IGBTs (13a) des zweiten Leistungsschalters der Halbbrücke sind mit dem Wechselstromanschlussleiter (30) über Drahtbondverbindungen (41) zu den Verbindungsbahnen (12), auf denen die IGBTs angeordnet sind, verbunden. Analog ist die Kathode der antiparallel geschalteten Leistungsdiode (13b) mit dem Wechselstromanschlussleiter (30) verbunden. Die Emitter der IGBTs sowie die Anode der Leistungsdiode sind mittels Drahtbondverbindungen (40, 44) direkt mit dem Minus-Gleichstromanschlussleiter (20a) verbunden.

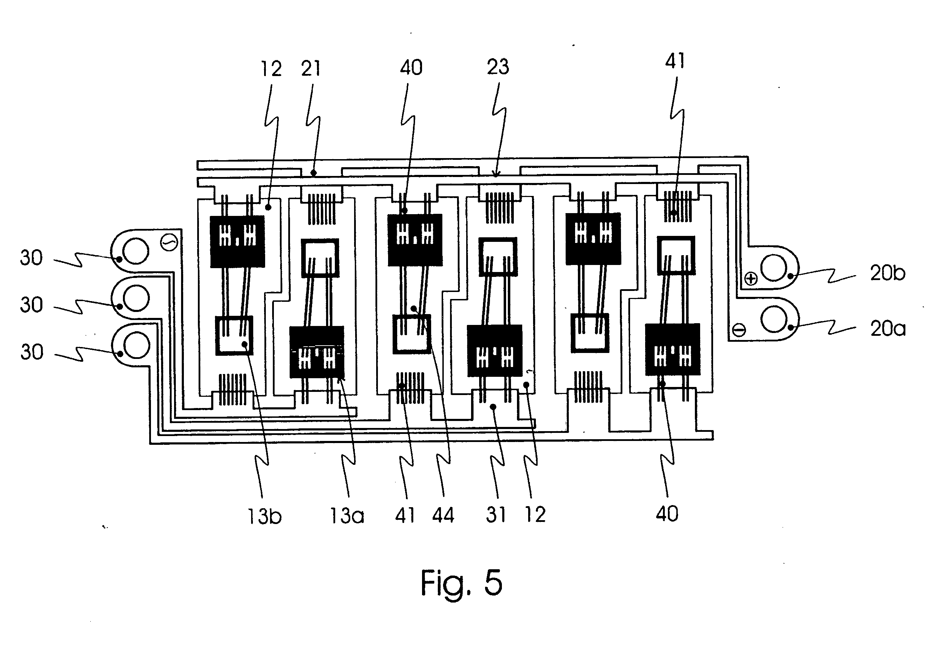

Fig. 5 zeigt eine erfindungsgemäße Schaltungsanordnung in 3- Phasen Wechselrichtertopologie. Es handelt sich hierbei prinzipiell um eine Aneinanderreihung dreier Halbbrücken (vgl. Fig. 4), wobei zur Vereinfachung jeder Leistungsschalter durch nur einen IGBT (13a) repräsentiert wird. Die Gleichstromanschlüsse (20) sind in analoger Weise zu den in Fig. 4 dargestellten ausgeführt, ebenfalls mit Aussparungen (23) des Minus-Gleichstromanschlussleiters (20a), damit Flächenelemente (21) des Plus-Gleichstromanschlussleiters (20b) hindurchragen können um die schaltungsgerechten Verbindungen realisieren zu können. Die erforderlichen drei Wechselstromanschlussleiter sind an der den Gleichstromanschlüssen gegenüberliegenden Seite der Schaltungsanordnung angeordnet und jeder in gleicher Weise wie unter Fig. 4 beschrieben kontaktiert.

## Patentansprüche

1. Schaltungsanordnung mit geringen parasitären Induktivitäten und geringem ohmschen Widerstand in den Stromzu- und abführungen für Leistungshalbleitermodule, bestehend aus mindestens einem elektrisch isolierenden Substrat (10) mit darauf befindlichen gegeneinander isolierten metallischen Verbindungsbahnen (12), darauf befindlichen Leistungshalbleiterbauelementen (13) sowie mindestens zwei Gleichstromanschlussleitern (20a, 20b) und mindestens einem Wechselstromanschlussleiter (30), wobei jeweils zwei Gleichstromanschlussleiter (20a, 20b) unterschiedlicher Polarität eng benachbart zueinander angeordnet sind und zumindest in einem wesentlichen Teilabschnitt parallel und eng benachbart zur Substratoberfläche (10) und / oder den Verbindungsbahnen (12) sowie, bei unterschiedlicher Polarität, elektrisch isoliert von diesen angeordnet sind, wobei der Wechselstromanschlussleiter (30) ebenfalls zumindest in einem Teilabschnitt eng benachbart zur Substratoberfläche (10) und / oder den Verbindungsbahnen (12) und, bei unterschiedlicher Polarität, elektrisch isoliert von diesen angeordnet ist und mindestens ein Anschlussleiter (20, 30) mindestens ein Flächenelement (21, 31) aufweist, welches parallel zur Substratoberfläche (10) angeordnet ist, und wobei dieses Flächenelement (21, 31) Verbindungen (40, 41) zu mindestens einem Leistungshalbleiterbauelement (13) und / oder zu mindestens einer Verbindungsbahn (12) aufweist, wobei mindestens ein Anschlussleiter (20, 30) mindestens eine Aussparung (23) aufweist, die auf der dem Substrat (10) zugewandten Seite angeordnet ist und hierbei das Flächenelement (21) eines benachbart angeordneten Anschlussleiters unter der Aussparung (23) hindurch ragt.

2. Schaltungsanordnung nach Anspruch 1, wobei
das Leistungshalbleitermodul ein das mindestens eine Substrat (10) umschließendes Gehäuse aufweist, welches die Anschlussleiter mechanisch stützt und fixiert, sowie Aussparungen aufweist und die Anschlussleiter (20, 30) durch diese Aussparungen aus dem Gehäuse heraus ragen und dort zur externen Kontaktierung des Leistungshalbleitermoduls Kontaktelemente (24, 34) aufweisen.

3. Schaltungsanordnung nach Anspruch 1, wobei
der Wechselstromanschlussleiter (30) ebenfalls zumindest in einem Teilabschnitt eng benachbart zur Substratoberfläche (10) und / oder den Verbindungsbahnen (12) und, falls benötigt, elektrisch isoliert von diesen angeordnet ist.

4. Schaltungsanordnung nach Anspruch 1, wobei
die Verbindungen (40, 41) zwischen den Flächenelementen (21, 31) Drahtbondverbindungen sind.

5. Schaltungsanordnung nach Anspruch 1, wobei
auf dem Substrat (10) und / oder auf mindestens einer Verbindungsbahn (12) mindestens ein weiteres Bauelement (14), beispielhaft ein Sensor, angeordnet ist.

6. Schaltungsanordnung nach Anspruch 1, wobei
mindestens ein Anschlussleiter (20) mittels einer elektrisch isolierenden Schicht (22) von mindestens einer Verbindungsbahn (12) beabstandet angeordnet ist.

7. Schaltungsanordnung nach Anspruch 6, wobei
die elektrisch isolierende Schicht (22a) auch unterhalb mindestens eines Flächenelements (21, 31) angeordnet ist.

8. Schaltungsanordnung nach Anspruch 1, wobei
mindestens ein Anschlussleiter (20) mindestens ein Fußelement (26) zur Abstützung auf dem Substrat (10) aufweist.

## Claims

1. A circuit arrangement with low parasitic inductances and low ohmic resistance in the conductors supplying current to and from power semiconductor modules, consisting of at least one electrically insulating substrate (10) with metallic connecting tracks (12) located on the substrate that are insulated from one another, with power semiconductor components (13) located on the connecting tracks, and with at least two DC connecting conductors (20a, 20b) and at least one AC connecting conductor (30), wherein two DC connecting conductors (20a, 20b) of differing polarity are arranged closely adjacent to one another in each case, and, at least in a significant sub-section, are arranged parallel and closely adjacent to the substrate surface (10) and/or to the connecting tracks (12), and, with differing polarity, are arranged such that they are electrically insulated from the latter, wherein the AC connecting conductor (30) is likewise arranged, at least in a significant sub-section, closely adjacent to the substrate surface (10) and/or to the connecting tracks (12), and, with differing polarity, is arranged such that it is electrically insulated from the latter, and at least one connecting conductor (20, 30) has at least one surface element (21, 31) that is arranged parallel to the substrate surface (10), and wherein the said surface element (21, 31) has connections (40, 41) to at least one power semiconductor component (13) and/or to at least one connecting track (12), wherein at least one connecting conductor (20, 30) has at least one opening (23), which is arranged on the side facing towards the substrate (10) and by this means the surface element (21) of an adjacently arranged connecting conductor protrudes under and through the opening (23).

2. The circuit arrangement according to claim 1, wherein
the power semiconductor module has a housing enclosing the at least one substrate (10); the housing mechanically supports and fixes the connecting conductors; it also has openings and the connecting conductors (20, 30) protrude through these openings out of the housing, and there have contact elements (24, 34) so as to enable external contacts with the power semiconductor module.

3. The circuit arrangement according to claim 1, wherein
the AC connecting conductor (30) is likewise arranged, at least in a sub-section, closely adjacent to the substrate surface (10) and/or to the connecting tracks (12), and, if necessary, is arranged such that it is electrically insulated from the latter.

4. The circuit arrangement according to claim 1, wherein
the connections (40, 41) between the surface elements (21, 31) are wire-bonding connections.

5. The circuit arrangement according to claim 1, wherein
at least one further component (14), for example a sensor, is arranged on the substrate (10) and/or on at least one connecting track (12).

6. The circuit arrangement according to claim 1, wherein
at least one connecting conductor (20) is arranged such that it is spaced apart from at least one connecting track (12) by means of an electrically insulating layer (22).

7. The circuit arrangement according to claim 6, wherein
the electrically insulating layer (22a) is also arranged underneath at least one surface element (21, 31).

8. The circuit arrangement according to claim 1, wherein
at least one connecting conductor (20) has at least one foot element (26) for purposes of providing support on the substrate (10).

## Revendications

1. Circuit à faibles inductances parasites et à faible résistance ohmique dans les amenées et les évacuations de courant pour des modules à semi-conducteur de puissance, constitué d'au moins un substrat (10) électriquement isolant sur lequel se situent des pistes de connexion métalliques (12) isolées les unes des autres, sur lesquelles se situent des composants à semi-conducteur de puissance (13), et d'au moins deux conducteurs de connexion à courant continu (20a, 20b) et d'au moins un conducteur de connexion à courant alternatif (30), respectivement deux conducteurs de connexion à courant continu (20a, 20b) de polarité différente étant disposés à proximité immédiate l'un de l'autre et, au moins dans une section essentielle, étant disposés parallèlement à la surface (10) du substrat et/ou aux pistes de connexion (12) et à proximité immédiate de ces dernières, et, en cas de polarité différente, électriquement isolés de ces dernières, le conducteur de connexion à courant alternatif (30) étant également disposé au moins dans une section à proximité immédiate de la surface (10) du substrat et/ou des pistes de connexion (12) et, en cas de polarité différente, électriquement isolé de ces dernières, et d'au moins un conducteur de connexion (20, 30) comprenant au moins un élément plan (21, 31), lequel est disposé parallèlement à la surface (10) du substrat, et cet élément plan (21, 31) présentant des connexions (40, 41) à au moins un composant à semi-conducteur de puissance (13) et/ou à au moins une piste de connexion (12), au moins un conducteur de connexion (20, 30) présentant au moins un évidement (23), lequel est disposé sur la face tournée vers le substrat (10) et l'élément plat (21) faisant saillie au-dessous de l'évidement (23) d'un conducteur de connexion disposé au voisinage.

2. Circuit selon la revendication 1,
le module à semi-conducteur de puissance comprenant un boîtier entourant le au moins un substrat (10), lequel soutient et fixe mécaniquement les conducteurs de connexion, et comprenant également des évidements, et les conducteurs de connexion (20, 30) faisant saillie du boîtier en passant par ces évidements et présentant à cet endroit des éléments de contact (24, 34) destinés à établir une mise en contact électrique externe du module à semi-conducteur de puissance.

3. Circuit selon la revendication 1,
le conducteur de connexion à courant alternatif (30) étant disposé également au moins dans une section à proximité immédiate de la surface (10) du substrat et/ou des pistes de connexion (12) et, si nécessaire, isolé électriquement de ces dernières.

4. Circuit selon la revendication 1,
les connexions (40, 41) entre les éléments plans (21, 31) étant des connexions à soudure de fil.

5. Circuit selon la revendication 1,
au moins un autre composant (14), par exemple un capteur, étant disposé sur le substrat (10) et/ou sur au moins une piste de connexion (12).

6. Circuit selon la revendication 1,
au moins un conducteur de connexion (20) étant espacé d'au moins une piste de connexion (12) par une couche électriquement isolante (22).

7. Circuit selon la revendication 6,
la couche électriquement isolante (22a) étant également disposée au-dessous d'au moins un élément plan (21, 31).

8. Circuit selon la revendication 1,
au moins un conducteur de connexion (20) comprenant au moins un élément socle (26) destiné à servir d'appui au substrat (10).
